# FASCICULE DE BREVET EUROPEEN

(11) **EP 2 875 397 B1**
(45) Date de publication et mention de la délivrance du brevet: **04.01.2023**
(21) Numéro de dépôt: 13756537.0
(22) Date de dépôt: 16.07.2013
(51) Int. Cl.: G02B 27/01, H04N 9/31, G02F 1/15

(54) **DISPOSITIF ET PROCEDE D'EMISSION D'UN FAISCEAU LUMINEUX DESTINE A FORMER UNE IMAGE, SYSTEME DE PROJECTION ET AFFICHEUR UTILISANT LEDIT DISPOSITIF**
VORRICHTUNG UND VERFAHREN ZUM AUSSENDEN EINES LICHTSTRAHLS ZUR ERZEUGUNG EINES BILDES, PROJEKTIONSSYSTEM UND ANZEIGE MIT DIESER VORRICHTUNG
DEVICE AND METHOD FOR EMITTING A LIGHT BEAM INTENDED TO FORM AN IMAGE, PROJECTION SYSTEM, AND DISPLAY USING SAID DEVICE

(30) Priorité: 18.07.2012 FR 1256957
(43) Date de publication de la demande: 27.05.2015
(73) Titulaire: Valeo Comfort and Driving Assistance, 94046 Créteil Cedex (FR)
(72) Inventeur: IRZYK, Michael, F-94046 Créteil Cedex (FR); AUTRAN, Frédéric, F-94046 Créteil Cedex (FR)
(74) Mandataire: Pothmann, Karsten
(86) Numéro de dépôt international: PCT/FR2013/000186
(87) Numéro de publication internationale: WO 2014/013143

(56) Documents cités:
- DE-A1-102008 054 443
- FR-A1- 2 933 784
- US-A1- 2012 105 812
- US-B1- 6 574 030
- US-B2- 7 817 324

## Description

L'invention concerne un dispositif et un procédé d'émission d'un faisceau lumineux destiné à former une image, un système de projection utilisant ledit dispositif et un afficheur utilisant ledit système.

L'invention trouvera ses applications, par exemple, dans les véhicules automobiles pour informer les utilisateurs du véhicule, en particulier son conducteur.

Il est connu d'équiper un véhicule automobile avec un système d'affichage, dit tête haute. Un tel système est placé dans le champ de vision du conducteur automobile et affiche une information relative à l'état du véhicule automobile, du trafic ou autre.

Afin de ne pas perturber la conduite, il est nécessaire que la luminosité de l'image projetée soit adaptée à la luminosité ambiante. Il est en particulier nécessaire que la puissance optique de l'image projetée soit fortement différente lors d'un trajet diurne et d'un trajet nocturne ou lors d'un passage dans un tunnel.

Avec les afficheurs tête haute utilisant des diodes électroluminescentes, il a déjà été proposé de faire varier la luminosité de l'image projetée en contrôlant le courant d'alimentation des diodes. De tels dispositifs permettent une adaptation satisfaisante de la luminosité. Cependant, leur luminosité diurne reste insuffisante.

FR 2 933 784 A1 montre un dispositif d'affichage pour véhicule comprenant une source lumineuse et un miroir électro-chrome dont la réflectivité peut être adaptée pour varier la puissance optique du faisceau lumineux généré.

Pour pallier ce défaut, on connaît des afficheurs utilisant des sources lumineuses du type laser. Cependant l'adaptation de la luminosité offerte dans un tel cas en contrôlant la quantité de courant alimentant les sources ne permet pas de réduire suffisamment la puissance optique de l'image. A titre d'exemple, si l'on considère que l'on souhaite disposer d'une puissance optique de l'ordre de 10000 Cd/m2 dans des conditions de roulage diurne et de l'ordre de 5 Cd/m2 dans des conditions de roulage nocturne, on constate qu'il faut faire diminuer la luminosité d'un facteur 2000 lors d'un passage de l'une des conditions de roulage à l'autre.

Des recherches menées par la titulaire sur l'adaptation de la luminosité de l'image projetée par le contrôle de l'alimentation en courant des sources lumineuses, par exemple à l'aide de technologies de modulation de largeur d'impulsions ou de contrôle de l'intensité du courant utilisé, montrent que ces technologies présentent des limites. Il est notamment nécessaire d'avoir une durée minimum d'impulsion et une intensité minimum du courant pour le fonctionnement linéaire des diodes.

L'invention a pour objet de résoudre les problèmes précédents en proposant un dispositif d'émission d'un faisceau lumineux destiné à former une image, ledit dispositif comprenant une ou plusieurs sources, émettant chacune un faisceau du type laser, ledit dispositif étant configuré pour former ledit faisceau lumineux à partir du ou de la mise en commun par combinaison desdits faisceaux laser. Par mise en commun, on entend que lesdits faisceaux laser forment à l'œil nu, après combinaison, un seul faisceau lumineux bien qu'ils soient encore présents individuellement dans ledit faisceau. Par simplicité, on continuera d'utiliser dans la suite, le terme faisceau lumineux pour désigner la combinaison des faisceaux laser après mise en commun.

Selon l'invention, ledit dispositif comprend des moyens d'atténuation, situés en aval de la ou desdites sources, permettant de faire varier la puissance optique du faisceau lumineux en transmettant et/ou réfléchissant le ou lesdits faisceaux en fonction d'un courant d'alimentation desdits moyens d'atténuation. On entend par puissance optique la puissance lumineuse du flux lumineux émis par la ou les sources. Elle pourra aussi bien être mesurée, par exemple en milliwatt (mW), à partir du courant généré par une photodiode recevant le flux lumineux ou, en candela par mètre carré (Cd/m2), à partir de l'éclairement produit par le flux lumineux sur une surface donnée.

En atténuant le faisceau émis par les sources laser par des moyens spécifiques agissant de façon disctincte d'un pilotage de leur alimentation en courant, on dispose de plus grandes possibilités de réduction de la puissance optique. Par suite, on peut à la fois bénéficier d'une forte luminosité diurne et d'une faible luminosité nocturne. Par ailleurs, en utilisant des moyens d'atténuation fonctionnant à partir de leur alimentation en courant, on dispose d'une solution n'impliquant pas de pièces mobiles.

Selon l'invention, lesdits moyens d'atténuation comprennent un ou des miroirs électro-chrome. Ils pourront, par exemple, être disposés en série sur le trajet du ou desdits faisceaux. On peut de la sorte combiner leur facteur d'atténuation.

Selon l'invention, ledit dispositif d'émission comprend des moyens de pilotage de l'alimentation en courant desdites sources, lesdits moyens de pilotage étant configurés pour assurer un complément de réglage de la puissance optique dudit faisceau lumineux. On associe de la sorte les capacités de réglage de la puissance optique apportées par les moyens d'atténuation et les moyens de pilotage pour atteindre le facteur d'atténuation désiré, en particulier au moins 1000, voire 2000.

Lesdits moyens de pilotage pourront être configurés pour assurer une régulation linéaire en courant de la puissance optique desdits faisceaux laser de façon à assurer un choix de couleur du faisceau lumineux selon une proportion de puissance optique attribuée à chacun desdits faisceaux laser. On dispose de la sorte d'un mode de régulation dédié au choix de la couleur.

Lesdits moyens de pilotage pourront aussi être configurés pour assurer une régulation par modulation de largeur d'impulsion de la puissance optique desdits faisceaux laser de façon à réaliser ledit complément de réglage de la puissance optique dudit faisceau lumineux. On dispose de la sorte d'un mode de régulation dédié au complément de réglage de la puissance optique. Autrement dit, le facteur d'atténuation pourra résulter de l'action combinée desdits moyens d'atténuation et d'une modulation de largeur d'impulsion du courant d'alimentation desdites sources laser, ladite modulation étant réalisée à l'aide desdits moyens de pilotage.

Plus précisément, lesdits moyens de pilotage sont configurés pour que ladite régulation par modulation de largeur d'impulsion assure ledit complément de réglage, par exemple, selon un facteur d'atténuation compris entre 5 et 20, notamment de 10. De leur côté, les moyens d'atténuation pourront permettre d'obtenir un facteur d'atténuation compris entre 100 et 300, notamment d'environ 200, en particulier par disposition en série de plusieurs miroirs électro-chrome, comme évoqué plus haut.

Selon d'autres caractéristiques de l'invention qui pourront être prises ensemble ou séparément, éventuellement combinées à tout ou parties des caractéristiques précédentes:
- lesdits moyens d'atténuation sont configurés pour faire varier la puissance optique de l'un au moins desdits faisceaux laser avant sa combinaison avec l'un au moins des autres dits faisceaux laser, et/ou lesdits moyens d'atténuation sont configurés pour faire varier la puissance optique dudit faisceau lumineux issu de la combinaison desdits faisceaux laser,
- ledit dispositif comprend en outre des moyens de détection d'une luminosité ambiante et des moyens de traitement permettant d'agir sur lesdits moyens d'atténuation en fonction de la luminosité ambiante relevée par lesdits moyens de détection.

De manière avantageuse, ledit dispositif d'émission comprend au moins trois sources laser, chacune des trois sources étant apte à émettre un faisceau lumineux monochromatique.

Cela étant, l'invention concerne encore un système de projection d'image comprenant un dispositif d'émission d'un faisceau lumineux tel que décrit plus haut.

Ledit système comprend, par exemple, des moyens de formation d'une image à partir dudit faisceau lumineux. Lesdits moyens d'atténuation pourront être situés en amont et/ou en aval desdits moyens de formation d'image.

Lesdits moyens de formation d'image comprennent, par exemple, un écran diffuseur sur lequel se forme une image produite à partir de la ou des sources lumineuses dudit dispositif d'émission.

Selon une premier mode de mise en œuvre, lesdits moyens de formation d'image comprennent en outre un projecteur à balayage laser générateur d'un faisceau lumineux formant une image sur l'écran diffuseur à partir du faisceau lumineux généré par ledit dispositif d'émission.

Selon un autre de mode de réalisation, lesdits moyens de formation d'image comportent un projecteur comportant une matrice de micro miroirs interposée entre la ou les sources lumineuses et l'écran diffuseur, la matrice de micro miroirs formant une première image projetée sur l'écran diffuseur où se forme une seconde image projetée.

L'invention couvre aussi un système d'affichage tête haute comprenant un système de projection tel que décrit plus haut.

Un tel système comprend, par exemple, une lame semi-réfléchissante, apte à être disposée entre le volant et le pare-brise d'un véhicule, ou le pare-brise en tant que tel.

Le système selon l'invention pourra encore comprendre un dispositif de réflexion interposé sur le trajet de l'image entre l'écran diffuseur et la lame semi-réfléchissante. Un tel dispositif de réflexion permet d'installer plus facilement le dispositif de projection tout en renvoyant l'image à l'endroit souhaité, à partir d'un emplacement donné du dispositif d'émission.

L'invention concerne encore un procédé d'émission d'un faisceau lumineux destiné à former une image, procédé dans lequel on prévoit une ou plusieurs sources, émettant chacune un faisceau du type laser, on forme ledit faisceau lumineux à partir du ou de la mise en commun par combinaison desdits faisceaux laser et on fait varier la puissance optique dudit faisceau lumineux à l'aide de moyens d'atténuation, situés en aval de la ou desdites sources.

Selon l'invention, on assure un complément de réglage de la puissance optique dudit faisceau lumineux à l'aide de moyens de pilotage d'une alimentation en courant de la ou desdites sources, notamment selon les caractéristiques déjà évoquées plus haut.

Selon l'invention, ledit procédé exploite le dispositif d'émission décrit précédemment.

D'autres caractéristiques, détails et avantages de l'invention ressortiront plus clairement à la lecture de la description donnée ci-après à titre indicatif en relation avec des dessins dans lesquels :
- la figure 1 est une vue schématique d'un dispositif d'émission selon l'invention, dans un premier mode de fonctionnement,
- la figure 2 est une vue du dispositif de la figure 1 dans un second mode de fonctionnement,
- la figure 3 une vue du dispositif de la figure 1 dans un troisième mode de fonctionnement,
- la figure 4 est une vue schématique d'un système d'affichage tête haute selon l'invention.

Il faut noter que les figures exposent l'invention de manière détaillée pour mettre en œuvre l'invention, lesdites figures pouvant bien entendu servir à mieux définir l'invention le cas échéant.

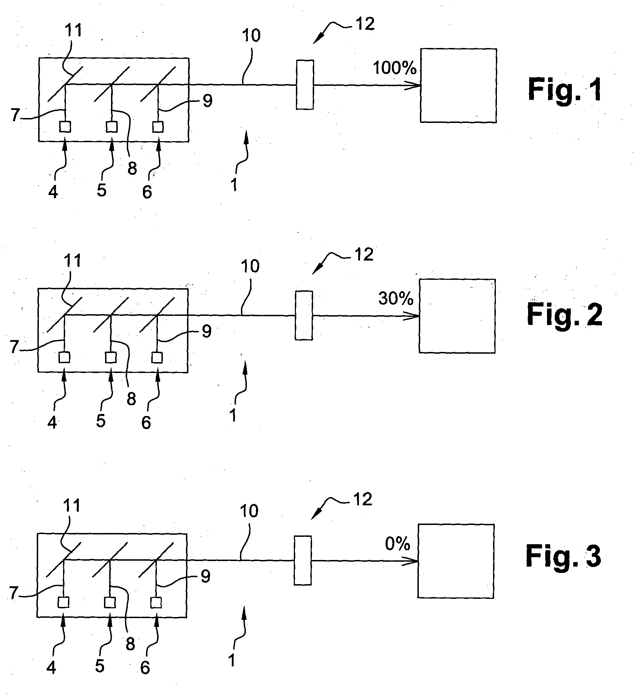

Comme illustré aux figures 1 à 3, l'invention concerne tout d'abord un dispositif 1 d'émission d'un faisceau lumineux, destiné à former une image. Un tel dispositif est plus particulièrement destiné à équiper un afficheur tête haute d'un véhicule automobile, où au moins une information en rapport avec le véhicule est projetée.

Ledit dispositif comprend une ou plusieurs sources 4, 5, 6 émettant chacune un faisceau 7, 8, 9 du type laser. Il s'agit, par exemple, de sources laser, typiquement des diodes laser, chaque source laser émettant un faisceau monochromatique, c'est-à-dire consistant en une seule couleur.

Ledit dispositif comprend ici une pluralité de sources 4, 5, 6, en l'occurrence trois, ledit dispositif étant configuré pour former le faisceau lumineux 10 à l'aide d'une mise en commun par combinaison des faisceaux 7, 8, 9 individuellement émis par chacune desdits sources 4, 5, 6. Plus précisément, il pourra s'agir de sources émettant un faisceau d'une couleur différente d'une source à l'autre. Les couleurs sont, par exemple, un rouge, un vert ou un bleu (RVB).

La puissance optique de chacune des sources est pilotée, de manière indépendante, à l'aide du courant d'alimentation de la ou des sources laser. A puissance optique donnée, la couleur du faisceau lumineux 10 est déterminée par la manière dont un ratio de puissance est établi entre les différentes diodes laser. Par exemple, pour obtenir une lumière blanche, les puissances optiques, en proportion, doivent être établies selon la distribution suivante : 60 pour la diode verte, 30 pour la diode bleue, 10 pour la diode rouge. Comme développé plus loin, la puissance optique de chacune des sources pourra également être pilotée pour moduler la puissance optique du faisceau lumineux 10.

Les faisceaux 7, 8, 9 émis par chacune des sources sont orientés, par exemple, parallèlement les uns aux autres et réfléchit dans une même direction pour former par combinaison ledit faisceau lumineux commun 10. Ledit dispositif 1 comprend ici en ce sens des éléments optiques semi-transparent, sur une plage de longueur d'onde, tels que des miroirs dichroïque ou lames de combinaison 11, interceptant les faisceaux 7, 8, 9 émis par chacune desdites sources et les combinant selon la direction dudit faisceau 10.

De façon plus générale, ledit dispositif 1 est configuré pour former ledit faisceau lumineux 10 à partir du ou desdits faisceaux laser 7, 8, 9, quel que soit le nombre de sources 4, 5, 6 en jeux. En cas de source unique, le faisceau lumineux 10 est composé du faisceau laser émis par la seule source employée et l'image obtenue sera alors monochrome, composée des différents niveaux de puissances optiques appliquées à chacun des points qui la compose, selon un dégradé de ladite couleur. En cas de pluralité de sources, typiquement les trois sources 4, 5, 6 évoquées plus haut, ledit faisceau commun 10 qui forme alors ledit faisceau lumineux permettra l'établissement d'une image selon un spectre de couleur dont la résolution correspondra à la finesse de pilotage de l'alimentation desdites sources 4, 5, 6.

Selon l'invention, ledit dispositif 1 comprend des moyens 12 d'atténuation, situés en aval de la ou desdites sources 4, 5, 6, permettant de faire varier la puissance optique du faisceau lumineux 10 en transmettant et/ou réfléchissant le ou lesdits faisceaux en fonction d'un courant d'alimentation desdits moyens d'atténuation 12. Autrement dit, une couleur et/ou une intensité étant conférées au faisceau lumineux 10 par le contrôle de l'alimentation en courant des sources, lesdits moyens 12 d'atténuation permettent de faire varier la puissance optique du ou des faisceaux 7, 8, 9, 10. On pourra en particulier adapter la puissance optique du faisceau à des conditions de roulage diurne et des conditions de roulage nocturne.

Ledit dispositif pourra comprendre des moyens de pilotage de l'alimentation en courant desdites sources. Comme évoqué plus haut, ils pourront permettre un choix de la couleur du faisceau lumineux 10.

Plus précisément, lesdits moyens de pilotage sont configurés, par exemple, pour assurer une régulation linéaire en courant de la puissance optique desdits faisceaux laser 7, 8, 9 de façon à assurer ledit choix de couleur du faisceau lumineux 10, selon une proportion de puissance optique attribuée à chacun desdits faisceaux laser 7, 8, 9. On pourra, par exemple, prévoir un codage de la couleur sur six bits, correspondant à soixante quatre niveaux de puissance optique pour chacun desdits faisceaux laser 7, 8, 9.

Lesdits moyens de pilotage pourront aussi être configurés pour assurer un complément de réglage de la puissance optique dudit faisceau lumineux. On peut de la sorte atteindre un taux d'atténuation particulièrement élevé.

Plus précisément, lesdits moyens de pilotage sont configurés pour assurer une régulation par modulation de largeur d'impulsion de la puissance optique desdits faisceaux laser 7, 8, 9 de façon à réaliser ledit complément de réglage de la puissance optique dudit faisceau lumineux 10, notamment selon un facteur d'atténuation compris entre 5 et 20, en particulier d'environ 10.

On peut de la sorte régler la couleur et/ou la puissance optique dudit faisceau lumineux 10. Lesdits moyens de pilotage comprennent, par exemple, un micro contrôleur, non représenté.

Lesdits moyens d'atténuation 12 comprennent, par exemple un ou des miroirs électro-chrome. De façon connue, lesdits miroirs réfléchissent plus ou moins la lumière en fonction d'un courant qui leur est appliqué. Ici un seul miroir est illustré mais il pourra en être prévue plusieurs, notamment disposés en série sur le trajet du ou desdits faisceaux 7, 8, 9, 10.

Chaque miroir pourra présenter, par exemple, un facteur d'atténuation d'environ 100. On peut de la sorte obtenir, avec deux miroirs en série, un facteur d'atténuation d'environ 200 qui, combiné au facteur d'atténuation provenant des moyens de pilotage, en particulier de la modulation de largeur d'impulsion, permettra d'atteindre le niveau de 2000 évoqué plus haut.

A la figure 1, lesdits moyens d'atténuation 12 sont alimentés avec un premier niveau de courant permettant une réflexion avoisinant 100% du faisceau lumineux 10. A la figure 2, lesdits moyens d'atténuation 12 sont alimentés avec un second niveau de courant permettant une réflexion de 30% du faisceau lumineux 10. A la figure 3, lesdits moyens d'atténuation 12 coupent la presque totalité de la réflexion du faisceau lumineux 10, comme symbolisé par le chiffre 0%.

Cela étant, selon la configuration illustrée, lesdits moyens d'atténuation 12 sont placés sur la trajectoire du faisceau lumineux commun 10. Autrement dit, lesdits moyens d'atténuation 12 sont configurés pour faire varier la puissance optique dudit faisceau lumineux commun 10. Plus précisément, ici, tout ou partie desdits miroirs électro-chrome sont placés sur la trajectoire du faisceau lumineux commun 10.

Selon une variante non illustrée, lesdits moyens d'atténuation 12 sont placés au moins en partie sur la trajectoire des faisceaux émis par les sources 4, 5, 6, ici, entres lesdites sources 4, 5, 6 et lesdits miroirs 11. Autrement dit, lesdits moyens d'atténuation 12 sont configurés pour faire varier la puissance optique du faisceau laser émis par chacune desdites sources 4, 5, 6. Plus précisément, tout ou partie desdits miroirs électro-chrome sont placés entres lesdites sources 4, 5, 6 et lesdits miroirs 11.

Ledit dispositif pourra en outre comprendre des moyens de détection d'une luminosité ambiante et des moyens de traitement permettant d'agir sur lesdits moyens d'atténuation en fonction de la luminosité ambiante relevée par lesdits moyens de détection. Lesdits moyens de détection de la luminosité ambiante comprennent, par exemple, un détecteur de lumière, tel que celui provoquant une modification des écrans du tableau de bord d'un véhicule. Lesdits moyens de traitement sont intégrés, par exemple, au niveau du micro contrôleur évoqué plus haut.

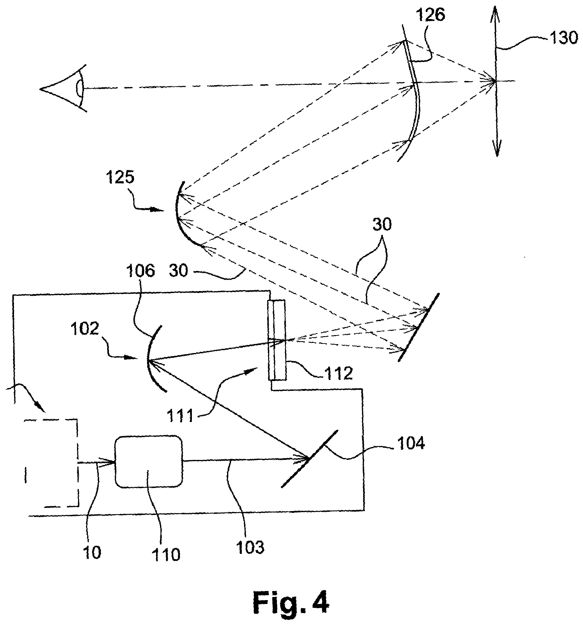

Comme illustré à la figure 4 l'invention concerne aussi un système 100 de projection d'image comprenant un dispositif d'émission 1 tel que décrit plus haut. Le système de projection 100 comprend en outre des moyens 102 de formation d'une image à partir dudit faisceau lumineux 10.

Lesdits moyens 102 de formation d'image comprennent, par exemple, un générateur de balayage 110 dont la fonction est de déplacer horizontalement et verticalement le faisceau lumineux 10 en vue de réaliser un balayage selon une fréquence, notamment égale à 60 Hz, à titre d'exemple non limitatif. Le générateur de balayage 110 comprend, notamment, un miroir à balayage à système micro-électro-mécanique (ci-après appelé miroir MEMS) sur lequel le faisceau lumineux 10 se réfléchit en un faisceau de balayage 103. Un tel miroir MEMS présente par exemple un diamètre de 1 mm. Le miroir MEMS est apte à tourner autour de deux axes de rotation pour réaliser un balayage, par exemple à la fréquence de rafraîchissement de 60 Hz, d'un écran diffuseur 111 desdits moyens 102 de formation d'une image. Ladite image se forme alors sur ledit diffuseur 111. Alternativement, le miroir MEMS peut être remplacé par deux miroirs plans et déplaçables, dont les mouvements sont associés. L'un de ces miroirs peut être dédié à un balayage selon un axe horizontal alors que l'autre miroir peut être dédié à un balayage selon un axe vertical.

Le diffuseur 111 où se forme l'image pourra être un écran de projection transparent à structure complexe pour une projection par transparence. Il pourra alternativement être translucide. Il est réalisé, par exemple, en verre, notamment dépoli, ou en polycarbonate. A titre d'exemple, l'écran diffuseur est du type à pupille de sortie (« Exit Pupil Expander »). Il permet de disposer d'un cône d'observation élargi. Il s'étend dans un plan traversé par le faisceau lumineux, l'image résultant de ce faisceau de balayage 103 étant formée dans le plan d'une face de l'écran diffuseur 111.

Cet écran diffuseur reçoit le faisceau de balayage 103. Il est agencé pour provoquer une dispersion de ce faisceau de balayage 103 selon un secteur angulaire, par exemple, égal à 30° par rapport à la direction du faisceau de balayage 103 au moment où il vient frapper l'écran diffuseur 111. Pour ce faire, selon un exemple non limitatif, une face 112 de l'écran diffuseur est rugueuse, en ce sens qu'elle comporte des aspérités qui provoquent la dispersion du faisceau de balayage 103. La face rugueuse 112 correspond à celle par laquelle le faisceau sort, c'est-à-dire la face sur laquelle l'image se forme.

Selon une autre variante non illustrée, lesdits moyens de formation d'image ne comportent pas de générateur de balayage, tel que précédemment décrit, mais une matrice de micro miroirs (aussi appelée Digital micro mirrors systems). Dans cette configuration l'image est formée au niveau de la matrice à micro miroirs puis projetée sur l'écran diffuseur. De manière générale, on place une optique de projection entre la matrice et l'écran. Chaque micro miroir correspond à un pixel de l'image. Dans ce mode de réalisation, l'image n'est pas formée sur l'écran diffuseur pour la première fois, mais reçoit une image préalablement formée sur la matrice à micro miroirs.

Il est à noter que lesdits moyens 12 d'atténuation pourront être, comme dans l'exemple illustré, en amont desdits moyens 102 de formation d'image. Ils pourront encore être en aval. Dans une variante, ils pourront être placés entre le générateur de balayage 110 ou la matrice de micro miroirs, d'une part, et, d'autre part, l'écran diffuseur 111.

Ledit système de projection pourra encore comprendre différents miroirs 104, 106, notamment sur la trajectoire du faisceau de balayage 103.

L'invention concerne encore un afficheur, notamment tête haute, comprenant un système de projection 100 selon l'une quelconque des variantes détaillées ci-dessus.

En aval de l'écran diffuseur 111 selon le sens de déplacement du faisceau lumineux, ledit afficheur comprend au moins une lame semi-réfléchissante 126 et un dispositif de réflexion 125 interposé sur le trajet de l'image entre l'écran diffuseur 111 et la lame semi-réfléchissante 126. Sur cette figure, le trajet de l'image est symbolisé par trois flèches 30 en pointillé qui se réfléchissent sur le dispositif de réflexion 125 avant de s'afficher à travers la lame semi-réfléchissante 126. Cette dernière permet un grossissement et/ou, par transparence, un affichage de l'image au-delà de ladite lame semi-réfléchissante, notamment au-delà du pare-brise du véhicule équipé, au niveau d'un écran virtuel 130, obtenu à l'aide de ladite lame semi-réfléchissante 126.

Cette lame transparente présente un pouvoir de réflexion au moins égale à 20%, ce qui permet à l'utilisateur de voir au travers de la lame la route empruntée par le véhicule, tout en bénéficiant d'un contraste élevé permettant de voir l'image affichée. De manière alternative, l'affichage de l'image peut avoir lieu au niveau du pare-brise du véhicule équipé dudit afficheur.

Comme déjà dit, lesdits moyens d'atténuation pourront être situés en aval du dispositif de formation d'image 102, ceci jusqu'à ladite lame semi-réfléchissante 126.

## Revendications

1. Dispositif d'émission d'un faisceau lumineux (10) destiné à former une image, ledit dispositif comprenant une ou plusieurs sources (4, 5, 6), émettant chacune un faisceau (7, 8, 9) du type laser, ledit dispositif étant configuré pour former ledit faisceau lumineux (10) à partir du ou de la mise en commun par combinaison desdits faisceaux laser (7, 8, 9), ledit dispositif comprenant des moyens (12) d'atténuation, situés en aval de la ou desdites sources (3, 4, 5), permettant de faire varier la puissance optique du faisceau lumineux (10) en réfléchissant le ou lesdits faisceaux en fonction d'un courant d'alimentation desdits moyens d'atténuation (12) et en ce que ledit dispositif comprend des moyens de pilotage de l'alimentation en courant desdites sources (4, 5, 6), lesdits moyens de pilotage étant configurés pour assurer un complément de réglage de la puissance optique dudit faisceau lumineux (10) et dans lequel lesdits moyens d'atténuation (12) comprennent un ou des miroirs électro-chrome.

2. Dispositif selon la revendication 1 dans lequel lesdits miroirs électro-chrome sont disposés en série sur le trajet du ou desdits faisceaux.

3. Dispositif selon l'une quelconque des revendications précédentes dans lequel lesdits moyens de pilotage sont configurés pour assurer une régulation linéaire en courant de la puissance optique desdits faisceaux laser (7, 8, 9) de façon à assurer un choix de couleur du faisceau lumineux (10) selon une proportion de puissance optique attribuée à chacun desdits faisceaux laser (7, 8, 9).

4. Dispositif selon l'une quelconque des revendications précédentes dans lequel lesdits moyens de pilotage sont configurés pour assurer une régulation par modulation de largeur d'impulsion de la puissance optique desdits faisceaux laser (7, 8, 9) de façon à réaliser ledit complément de réglage de la puissance optique dudit faisceau lumineux (10).

5. Dispositif selon la revendication 4 dans lequel lesdits moyens de pilotage sont configurés pour que ladite régulation par modulation de largeur d'impulsion assure ledit complément de réglage selon un facteur d'atténuation compris entre 5 et 20.

6. Dispositif selon l'une quelconque des revendications précédentes dans lequel lesdits moyens (12) d'atténuation sont configurés pour faire varier la puissance optique de l'un au moins desdits faisceaux laser (7, 8, 9) avant sa combinaison avec l'un au moins des autres dits faisceaux laser (7, 8, 9).

7. Dispositif selon l'une quelconque des revendications 1 à 5 dans lequel lesdits moyens (12) d'atténuation sont configurés pour faire varier la puissance optique dudit faisceau lumineux (10) issu de la combinaison desdits faisceaux laser (7, 8, 9).

8. Dispositif selon l'une quelconque des revendications précédentes comprenant en outre des moyens de détection d'une luminosité ambiante et des moyens de traitement permettant d'agir sur lesdits moyens (12) d'atténuation en fonction de la luminosité ambiante relevée par lesdits moyens de détection.

9. Système de projection d'image comprenant un dispositif selon l'une quelconque des revendications précédentes.

10. Système selon la revendication 9 comprenant des moyens (102) de formation d'une image à partir dudit faisceau lumineux (10) et dans lequel lesdits moyens d'atténuation (12) sont situés en aval desdits moyens (102) de formation d'image.

11. Afficheur, notamment afficheur tête haute, comprenant au moins un système de projection selon l'une quelconque des revendications 9 ou 10.

12. Procédé d'émission d'un faisceau lumineux (10) destiné à former une image au moyen du dispositif selon l'une des revendications 1 à 8, procédé dans lequel on prévoit une ou plusieurs sources (4, 5, 6), émettant chacune un faisceau (7, 8, 9) du type laser, on forme ledit faisceau lumineux (10) à partir du ou de la mise en commun par combinaison desdits faisceaux laser (7, 8, 9) et on fait varier la puissance optique dudit faisceau lumineux (10) à l'aide de moyens (12) d'atténuation, situés en aval de la ou desdites sources (3, 4, 5), lesdits moyens (12) d'atténuation réfléchissant le ou lesdits faisceaux en fonction d'un courant d'alimentation desdits moyens d'atténuation (12) et dans lequel on assure un complément de réglage de la puissance optique dudit faisceau lumineux (10) à l'aide de moyens de pilotage d'une alimentation en courant de la ou desdites sources (4, 5, 6).

## Patentansprüche

1. Vorrichtung zur Aussendung eines Lichtbündels (10) zur Bildung eines Bilds, wobei die Vorrichtung eine oder mehrere Quellen (4, 5, 6) umfasst, die jeweils ein Laserbündel (7, 8, 9) aussenden, wobei die Vorrichtung dazu ausgebildet ist, das Lichtbündel (10) anhand des oder der Zusammenlegung durch Kombination der Laserbündel (7, 8, 9) zu bilden, wobei die Vorrichtung Dämpfungsmittel (12) umfasst, die sich stromab der Quelle(n) (3, 4, 5) befinden, mit denen die optische Leistung des Lichtbündels (10) variiert werden kann, indem das oder die Bündel in Abhängigkeit von einem Versorgungsstrom der Dämpfungsmittel (12) reflektiert werden, und dadurch, dass die Vorrichtung Mittel zur Steuerung der Stromversorgung der Quellen (4, 5, 6) umfasst, wobei die Steuermittel dazu ausgebildet sind, eine ergänzende Regelung der optischen Leistung des Lichtbündels (10) zu gewährleisten, und wobei die Dämpfungsmittel (12) einen oder mehrere Elektrochrom-Spiegel umfassen.

2. Vorrichtung nach Anspruch 1, wobei die Elektrochrom-Spiegel auf der Bahn des oder der Bündel in Reihe angeordnet sind.

3. Vorrichtung nach einem der vorhergehenden Ansprüche, wobei die Steuermittel dazu ausgebildet sind, eine lineare Stromregulierung der optischen Leistung der Laserbündel (7, 8, 9) zu gewährleisten, um eine Farbwahl des Lichtbündels (10) gemäß einem Anteil optischer Leistung zu gewährleisten, der jedem der Laserbündel (7, 8, 9) zugewiesen wird.

4. Vorrichtung nach einem der vorhergehenden Ansprüche, wobei die Steuermittel dazu ausgebildet sind, eine Regulierung durch Pulsweitenmodulation der optischen Leistung der Laserbündel (7, 8, 9) zu gewährleisten, um die ergänzende Regelung der optischen Leistung des Lichtbündels (10) zu bewirken.

5. Vorrichtung nach Anspruch 4, wobei die Steuermittel so ausgebildet sind, dass die Regulierung durch Pulsweitenmodulation die ergänzende Regelung gemäß einem Dämpfungsfaktor zwischen 5 und 20 gewährleistet.

6. Vorrichtung nach einem der vorhergehenden Ansprüche, wobei die Dämpfungsmittel (12) dazu ausgebildet sind, die optische Leistung wenigstens eines der Laserbündel (7, 8, 9) vor dessen Kombination mit wenigstens einem der anderen Laserbündel (7, 8, 9) zu variieren.

7. Vorrichtung nach einem der Ansprüche 1 bis 5, wobei die Dämpfungsmittel (12) dazu ausgebildet sind, die optische Leistung des Lichtbündels (10), das aus der Kombination der Laserbündel (7, 8, 9) hervorgeht, zu variieren.

8. Vorrichtung nach einem der vorhergehenden Ansprüche, ferner umfassend Mittel zur Erkennung einer Umgebungshelligkeit und Verarbeitungsmittel, mit denen auf die Dämpfungsmittel (12) in Abhängigkeit von der Umgebungshelligkeit gewirkt werden kann, die von den Erkennungsmitteln erfasst wird.

9. Bildprojektionssystem umfassend eine Vorrichtung nach einem der vorhergehenden Ansprüche.

10. System nach Anspruch 9, umfassend Mittel (102) zum Bilden eines Bilds anhand des Lichtbündels (10) und wobei sich die Dämpfungsmittel (12) stromab der Bildbildungsmittel (102) befinden.

11. Anzeige, insbesondere Head-up-Anzeige, umfassend wenigstens ein Projektionssystem nach einem der Ansprüche 9 oder 10.

12. Verfahren zur Aussendung eines Lichtbündels (10) zur Bildung eines Bilds mittels der Vorrichtung nach einem der Ansprüche 1 bis 8, wobei bei dem Verfahren eine oder mehrere Quellen (4, 5, 6) vorgesehen werden, die jeweils ein Laserbündel (7, 8, 9) aussenden, das Lichtbündel (10) anhand des oder der Zusammenlegung durch Kombination der Laserbündel (7, 8, 9) gebildet wird und die optische Leistung des Lichtbündels (10) mithilfe von Detektionsmitteln (12) variiert wird, die sich stromab der Quelle(n) (3, 4, 5) befinden, wobei die Dämpfungsmittel (12) das oder die Bündel in Abhängigkeit von einem Versorgungsstrom der Dämpfungsmittel (12) reflektieren und wobei eine ergänzende Regelung der optischen Leistung des Lichtbündels (10) mithilfe von Mitteln zur Steuerung einer Stromversorgung der Quellen(n) (4, 5, 6) gewährleistet wird.

## Claims

1. Device for emitting a light beam (10) intended to form an image, said device comprising one or more sources (4, 5, 6), each emitting a beam (7, 8, 9) of the laser type, said device being configured to form said light beam (10) from the one laser beam or from the bringing together of said laser beams (7, 8, 9) by combination, said device comprising attenuation means (12) situated downstream of said source or sources (3, 4, 5), making it possible to vary the optical power of the light beam (10) by reflecting said beam or beams as a function of a supply current of said attenuation means (12) and in that said device comprises means for controlling the current supply of said sources (4, 5, 6), said control means being configured to provide additional adjustment of the optical power of said light beam (10) and in which said attenuation means (12) comprise one or more electrochromic mirrors.

2. Device according to Claim 1, in which said electrochromic mirrors are disposed in series over the path of said beam or beams.

3. Device according to either one of the preceding claims, in which said control means are configured to provide linear current regulation of the optical power of said laser beams (7, 8, 9) in order to provide a choice of colour of the light beam (10) according to a proportion of optical power allocated to each of said laser beams (7, 8, 9).

4. Device according to any one of the preceding claims, in which said control means are configured to provide regulation by pulse width modulation of the optical power of said laser beams (7, 8, 9) in order to achieve said additional adjustment of the optical power of said light beam (10).

5. Device according to Claim 4, in which said control means are configured so that said regulation by pulse width modulation provides said additional adjustment according to an attenuation factor of between 5 and 20.

6. Device according to any one of the preceding claims, in which said attenuation means (12) are configured to vary the optical power of at least one of said laser beams (7, 8, 9) before its combination with at least one of said other laser beams (7, 8, 9).

7. Device according to any one of Claims 1 to 5, in which said attenuation means (12) are configured to vary the optical power of said light beam (10) coming from the combination of said laser beams (7, 8, 9).

8. Device according to any one of the preceding claims, furthermore comprising means of detecting ambient brightness and processing means making it possible to act on said attenuation means (12) as a function of the ambient brightness measured by said detection means.

9. Image projection system comprising a device according to any one of the preceding claims.

10. System according to Claim 9, comprising means (102) for forming an image from said light beam (10) and in which said attenuation means (12) are situated downstream of said image forming means (102).

11. Display, notably a head-up display, comprising at least a projection system according to either one of Claims 9 and 10.

12. Method for emitting a light beam (10) intended to form an image by means of the device according to one of Claims 1 to 8, in which method there is provided one or more sources (4, 5, 6), each emitting a beam (7, 8, 9) of the laser type, said light beam (10) being formed from the one laser beam or from the bringing together of said laser beams (7, 8, 9) by combination and the optical power of said light beam (10) being varied using attenuation means (12) situated downstream of said source or sources (3, 4, 5), said attenuation means (12) reflecting said beam or beams as a function of a supply current of said attenuation means (12) and in which additional adjustment of the optical power of said light beam (10) is provided using means for controlling a current supply of said source or sources (4, 5, 6).
